**Europäisches Patentamt**

**European Patent Office**

**Office européen des brevets**

(11) Numéro de publication: **0 058 095**

**B1**

(12) **FASCICULE DE BREVET EUROPÉEN**

(45) Date de publication du fascicule du brevet:
23.07.86

(21) Numéro de dépôt: **82400006.1**

(22) Date de dépôt: **05.01.82**

(51) Int. Cl.⁴: **G 01 S 7/28,** G 01 S 13/78,
G 01 S 13/80, G 01 R 29/027

(54) Dispositif de détermination de l'instant d'arrivée d'impulsions à utiliser dans un équipement de mesure de distances.

(30) Priorité: **09.01.81 FR 8100315**

(43) Date de publication de la demande:
**18.08.82 Bulletin 82/33**

(45) Mention de la délivrance du brevet:
**23.07.86 Bulletin 86/30**

(84) Etats contractants désignés:
**DE GB IT NL**

(56) Documents cité:
**FR-A-1 571 354**
**FR-A-2 441 853**
**US-A-3 543 159**

**IEEE TRANSACTIONS ON AEROSPACE AND NAVIGATIONAL ELECTRONICS, vol. ANE-12, no. 1, mars 1965 New York, US C.J. HIRSCH: "A TACAN-compatible accurate DME for short ranges", pages 68-76**
**PHILIPS TECHNICAL REVIEW, vol. 35 no. 10, octobre 1975 Eindhoven, NL B.D. CORBETT: "MADGE II: The data linkdata transmission and distance measurement", pages 271-289**

(73) Titulaire: **THOMSON- CSF, 173, Boulevard Haussmann, F-75379 Paris Cedex 08 (FR)**

(72) Inventeur: **Hetyei, Joseph, THOMSON- CSF SCPI 173, bld Haussmann, F-75360 Paris Cedex 08 (FR)**

(74) Mandataire: **Benoit, Monique, THOMSON- CSF SCPI 19, avenue de Messine, F-75008 Paris (FR)**

## Description

La présente invention concerne un dispositif de détermination de l'instant d'arrivée d'impulsions, principalement dans le cas où ces impulsions ont des fronts de montée différents. L'invention concerne également l'utilisation d'un tel dispositif dans les équipements de mesure de distances connus sous le sigle DME pour "Distance Measuring Equipment" dans la terminologie anglosaxonne, et l'équipement comportant un tel dispositif.

Dans certains équipements relevant de la classe des équipements de détection électromagnétique et en particulier pour les équipements de mesure de distances (DME) les impulsions utilisées doivent être conformes à certaines normes et définitions.

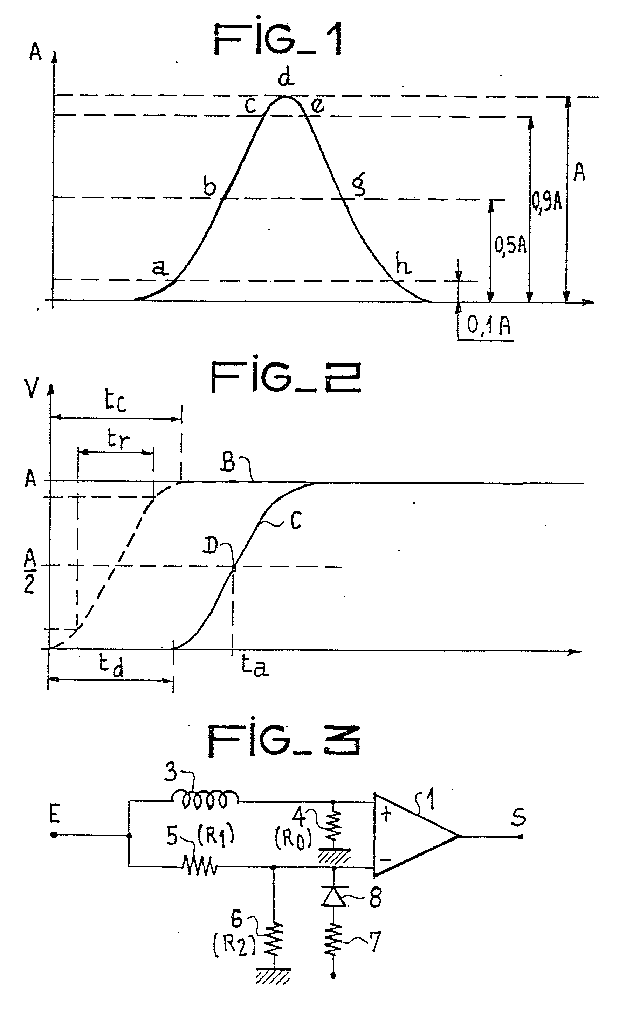

La figure 1 représente la forme générale des impulsions utilisées dans un DME pour lesquelles certaines définitions sont rappelées dans ce qui suit.

L'amplitude de l'impulsion est l'amplitude maximale A de son enveloppe. La durée de l'impulsion est l'intervalle de temps compris entre les points b et g, situés respectivement sur les flancs avant et arrière de l'impulsion au niveau 0,5 A.

La durée d'établissement de l'impulsion est la durée totale d'établissement mesurée entre les points a, à 0,1A sur le flanc avant de l'enveloppe de l'impulsion et c à 0,9A sur le même flanc avant.

La durée d'extinction de l'impulsion est la durée totale d'extinction mesurée entre les points e, à 0,9A sur le flanc arrière de l'enveloppe de l'impulsion et h, à 0,1A sur ce même flanc arrière.

Ces impulsions étant utilisées pour déterminer la distance séparant un mobile d'un point quelconque, une balise par exemple, l'instant d'arrivée d'une telle impulsion dans l'équipement de mesure, tant à bord du mobile qu'au sol doit être connu avec précision et en particulier échapper aux erreurs qui naîtraient d'une modification de la forme du signal reçu due à des parasites. Bien évidemment la mesure de la distance n'est pas limitée à des mobiles aériens; elle peut également s'appliquer à des mobiles terrestres ou maritimes. Cette détermination est particulièrement importante dans les équipements de mesure de distance ou DME, dans lesquels on veut connaître la distance entre un mobile aérien et une station au sol qui peut être le point d'atterrissage de l'aéronef.

Un dispositif de détermination de l'instant d'arrivée d'impulsions est connu, utilisé dans un DME dit "en route" qui cherche à connaître la distance entre un aéronef en vol et une station.

Cet équipement, DMF en route, utilise des impulsions de forme Gaussienne de front de montée de l'ordre de 2,5 us entre 10% et 90%, en fait compris entre 1 et 3 µs. La détermination ou aussi la détection de l'instant d'arrivée d'une impulsion de ce type est réalisée par un circuit comparateur d'amplitude élaborant la décision à mi-hauteur de l'impulsion. Le dispositif de l'art antérieur comporte alors un détecteur de crête qui prend la valeur de crête de l'impulsion puis applique la moitié de cette valeur crête sur l'entrée d'un comparateur d'amplitude qui reçoit sur l'autre entrée l'impulsion convenablement retardée par une ligne à retard. La figure 2 donne un diagramme temporel de l'exécution de cette mesure, représentant l'amplitude V de l'impulsion utilisée en fonction du temps t. La courbe B représente l'impulsion utilisée dans l'équipement qui atteint son amplitude maximale A au bout d'un temps tc, supérieur au temps tr dit temps de montée conformément à la norme rappelée précédemment. La courbe C représente l'impulsion retardée du temps td, td étant approximativement égale au temps tc. L'instant d'arrivée ta de l'impulsion est marqué par le point D, où l'impulsion atteint la moitié de la valeur crête soit 1/2 A.

Cependant et principalement lorsque l'on veut déterminer la distance entre l'aéronef et la station au sol avec plus de précision, dans le cas où la station au sol est le point d'atterrissage de l'aéronef, ce dispositif n'est plus assez précis car il devient sensible à des phénomènes extérieurs parasites, en fait aux réflexions dues aux multitrajets qui provoquent des modifications de la forme du signal reçu et ceci jusqu'à l'obtention de la valeur crête de l'impulsion c'est-à-dire jusqu'au basculement du comparateur utilisé dans le dispositif de détermination. Ces modifications dans la forme de la courbe conduisent à un positionnement erroné du point D.

Pour remédier à ces inconvénients, on a proposé un dispositif répondant à une autre méthode de détermination du temps d'arrivée des impulsions et travaillant avec des impulsions de front de montée plus rapide, généralement de l'ordre de 1 µs.

Un dispositif ainsi perfectionné est connu sous le nom de D.A.C. pour (Delay And Compare), c'est-à-dire que le fonctionnement de ce circuit est basé sur un retard et une comparison.

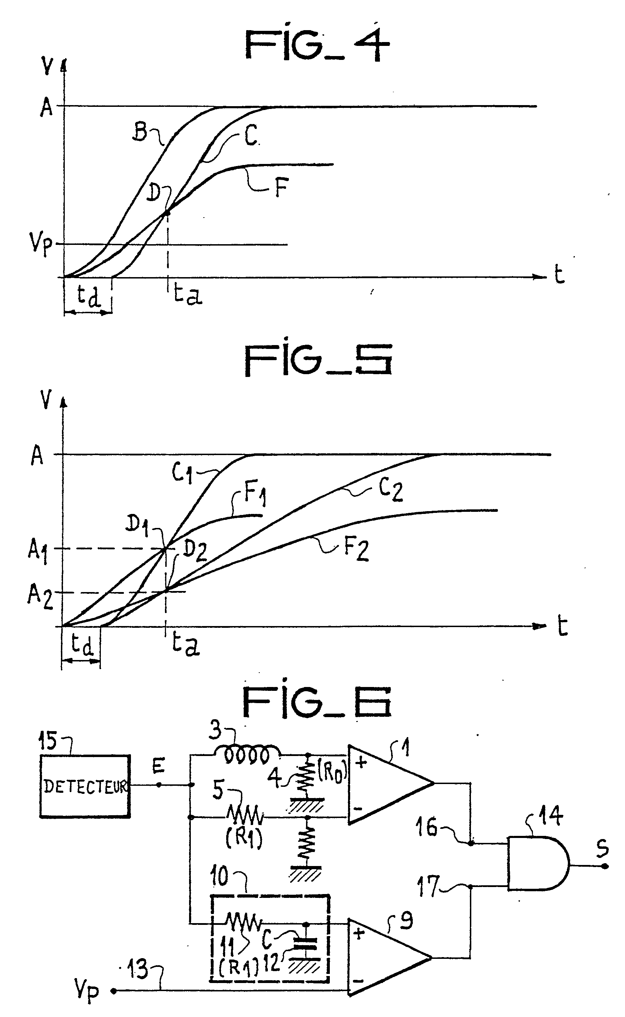

La figure 3 représente un tel dispositif et la figure 4 les impulsions utilisées dans un diagramme amplitude-temps.

Le dispositif de détermination de l'instant d'arrivée d'une impulsion, perfectionné par rapport à celui évoqué précédemment comporte un comparateur sous la forme d'un amplificateur différentiel 1 dont une entrée, généralement l'entrée positive, est alimentée à partir de l'entrée E du dispositif par un circuit comportant une ligne à retard 3 adaptée sur une résistance caractéristique 4, de valeur Ro et dont l'entrée négative est connectée à l'entrée E du dispositif par un circuit comprenant un diviseur de tension constitué par une résistance 5, de valeur R1, en série avec une résistance 6, de valeur R2. Une tension de polarisation +Vp est appliquée à l'entrée négative du comparateur 1 à travers une résistance 7 et une diode 8.

A l'aide de ce circuit, on cherche à déterminer l'instant d'arrivée de l'impulsion après sa réception, sans attendre qu'elle ait atteint sa valeur crête. Dans ce cas, le temps dit de détection est alors inférieur au temps de montée tr.

De ce fait, le dispositif DAC de la figure 3 est beaucoup moins sensible aux multitrajets que le dispositif décrit précédemment et donne une meilleure précision de la mesure, précision nécessaire lorsque l'aéronef se trouve en approche et/ou en atterrissage où précisemment l'effet des multitrajets peut être important et nocif.

Dans ce dispositif, l'impulsion qui est appliquée à l'entrée E, est représenté par le signal B sur la figure 4 qui donne le diagramme amplitude-temps des différents signaux utilisés dans le dispositif. Cette impulsion est d'une part atténuée, signal F, par le pont diviseur résistif 5—6 (R1, R2) et appliquée à l'entrée négative du comparateur et d'autre part retardée dans la ligne 3 (signal C) d'un temps td relativement faible avant d'être appliquée à l'entrée positive du comparateur. Le point de croisement D de l'impulsion atténuée F et de l'impulsion retardée C non atténuée donne l'instant d'arrivée ta de l'impulsion reçue.

Pour éviter le déclenchement du comparateur par le bruit qui, du fait de l'atténuation

$$k = \frac{R2}{R1+R2},$$

est plus fort sur l'entrée non inverseur, c'est-à-dire positive que sur l'entrée inverseur c'est-à-dire négative, on applique sur cette dernière une tension de polaristion de protection $V_P$ dont l'amplitude est légèrement supéieure à l'amplitude du bruit, avec le niveau de protection souhaité. On notera qu'une entrée non inverseur, dans un comparateur est celle qui recevant un signal d'un signe déterminé, correspond à une sortie délivrant un signal de même signe.

On constate qu'avec le dispositif DAC l'effet des réflexions parasites dues aux multitrajets n'intervient que pendant un temps très court, nettement inférieur au temps ta marquant l'instant d'arrivée de l'impulsion.

Ce dispositif DAC améliore donc le problème de la détermination de l'instant d'arrivée d'une impulsion en réduisant l'effet des multitrajets par rapport à un circuit de type détecteur crête. Pour un temps de montée déterminé des impulsions à recevoir les paramètres du dispositif, c'est-à-dire le retard td et l'atténuation k sont choisis en conséquence.

Il est alors nécessaire de considérer comment réagit ce dispositif DAC déterminé généralement pour des impulsions à temps de montée inférieur à 2,5 μ lorsqu'on lui applique une impulsion de temps de montée relativement important, par exemple de l'ordre de ou supérieur à 2,5 μs. La figure 5 donne un diagramme en fonction du temps de la réponse du dispositif DAC pour deux impulsions de temps de montée différents. Le signal C1 est l'impulsion de temps de montée court retardée du temps td, le signal F1 est l'impulsion atténuée non retardée. Le signal C2 est l'impulsion de temps de montée long retardée et F2 l'impulsion atténuée non retardée correspondante. Les points D1 et D2 caractérisent respectivement les instants d'arrivée ta des deux impulsions et l'on constate que les niveaux A1 et A2 auxquels la décision doit être prise sont différents; le niveau auquel la décision est obtenue sur l'impulsion lente C2, soit A2 est nettement inférieur au niveau A1 relatif à l'impulsion rapide C1.

Ce résultat a des répercussions fâcheuses lorsque le dispositif de détermination peut ou doit être utilisé avec les deux sortes d'impulsions. Ce cas se trouve être celui d'un DME dit de précision opérant en phase d'approche ou d'atterrissage d'un aéronef et qui peut néanmoins recevoir des impulsions lentes du type de celles utilisées actuellement dans un DME dit en route, pour lequel la précision joue un rôle moins important. Avec le circuit DAC décrit le bon fonctionnement du dispositif avec une impulsion lente exige un rapport signal sur bruit supérieur au rapport signal sur bruit de l'impulsion rapide puisque le niveau où s'effectue la détermination de l'instant d'arrivée de l'impulsion lente C2 soit A2 est plus bas que le niveau A1. Il y a une perte de sensibilité en cas de réception des impulsions de temps de montée lent.

De plus, la bande passante du récepteur est calculée pour la transmission de l'impulsion rapide, c'est-à-dire qu'elle se trouve beaucoup plus large que nécessaire pour la réception d'une impulsion lente, provoquant de la sorte une perte en rapport signal sur bruit pour cette impulsion.

Un objet de la présente invention est de définir un dispositif de détermination de l'instant d'arrivée d'impulsions de différents fronts de montée qui échappe aux inconvénients signalés.

Un autre objet de la présente invention est une amélioration du comportement du dispositif contre les faux déclenchements sur la bruit.

Suivant l'invention, un dispositif de détermination de l'instant d'arrivée d'impulsions, comprenant des premiers moyens de comparaison recevant sur une entrée une impulsion vidéo dont on veut déterminer l'instant d'arrivée et qui est retardée d'un temps défini, et sur une autre entrée, cette impulsion non retardée mais atténuée, ces moyens délivrant une information temporelle correspondant au point de croisement des deux impulsions situé à un niveau supérieur à une tension de seuil définissant le niveau du bruit maximum du dispositif est caractérisé en ce qu'il comprend en outre, des seconds moyens de comparaison connectés en parallèle sur les premiers à un circuit logique ET, et des moyens d'action, par filtrage, sur le bruit et/ou le signal qu'il reçoit, recevant les impulsions appliquées à l'entrée du dispositif et ayant leur sortie connectée à une entrée des seconds moyens de comparaison dont l'autre entrée est connectée à une source de tension de polarisation d'un niveau juste supérieur au niveau bruit, le circuit logique ET, délivrant une impulsion marquant l'instant d'arrivée suivant le cas, d'une impulsion à front de montée rapide ou d'une impulsion à front de montée lent.

D'autres avantages et caractéristiques de l'invention apparaîtront au cours de la description d'exemples de réalisation, donnés à l'aide, outre des figures 1 à 5 relatives à l'art antérieur, des figures qui représentent:

la figure 6, une réalisation du dispositif suivant l'invention;

les figures 7a à e, un diagramme en fonction du temps montrant le fonctionnement du dispositif pour une impulsion rapide;

les figures 8a à e, un diagramme fonction du temps montant le fonctionnement du dispositif pour une impulsion lente;

la figure 9, une autre réalisation du dispositif suivant l'invention;

les figures 10a à e, un diagramme fonction du temps montrant le fonctionnement du dispositif selon la réalisation de la figure 9.

les figures 11 et 12, des diagrammes montrant l'amélioration obtenue contre les faux déclenchements sur le bruit;

les figures 13 et 14 des diagrammes montrant comment le montage selon la figure 9 permet de choisir le niveau de décision sur l'impulsion lente;

la figure 15, un diagramme schématique d'un interrogateur DME à bord, incorporant le dispositif suivant l'invention et,

la figure 16, un diagramme schématique d'un transpondeur DME au sol, incorporant le dispositif suivant l'invention.

Comme cela a été défini dans l'introduction à la présente description, l'invention se propose de réaliser un dispositif de détermination des instants d'arrivée d'impulsions ayant des fronts de montée différents, les unes étant dites rapides, les autres lentes et également dans ce cadre d'améliorer la protection contre les faux déclenchements dus au bruit. Ce dispositif doit fonctionner quel que soit le type d'impulsion qui se présente à son entrée, et ce sans commutation, c'est-à-dire qu'il doit assurer cette détermination pour des impulsions rapides sans réduction de la bande passante et pour des impulsions lentes avec une bande passante généralement réduite. Dans ce cas, pour les impulsions de front de montée lent le dispositif fonctionnera avec un rapport signal sur bruit plus faible que le circuit DAC de l'art antérieur auquel on aurait appliqué une impulsion lente.

Un autre avantage, dans le cas de l'application d'une impulsion lente telle qu'utilisée dans un DME, en "route", est que le gain obtenu en rapport signal sur bruit permet un accroissement de la distance couverte pour une puissance donnée à l'émission; il permet également de réduire la puissance émise pour une distance déterminée, ceci en comparaison avec un circuit DAC de l'art antérieur.

La figure 6 représenté le dispositif suivant l'invention.

Il comporte un premier comparateur 1 alimenté à partir de son entrée E, qui peut être la sortie d'un détecteur vidéo dans le cas d'une utilisation dans un équipement de détection électromagnétique ou d'un équipement de mesure de distance, par deux branches, une première comprenant une ligne à retard 3 connectée à la borne positive du comparateur 1 et une seconde comprenant un ensemble de résistances 5 et 6, ou R1 et R2 montées en diviseur de tension, connecté à la borne négative ou inverseur du comparateur 1. La sortie de ce comparateur 1 est connectée à l'entrée 16 d'un circuit logique ET, 14 dont la sortie S est celle du dispositif. Ce dispositif comporte également un second comparateur 9 monté en parallèle sur le premier à travers le circuit ET 14 et alimenté à partir de l'entrée E, par une branche comportant un ensemble de filtrage 10, constitué dans la variante de la figure 6 par une résistance 11 et un condensateur 12, soit R et C, formant un filtre passe bas et connecté à la borne positive du comparateur, dont la borne négative est connectée à une source de polarisation Vp par la connexion 13. La sortie du comparateur 9 est connectée à la seconde entrée 17 du circuit logique ET, 14.

On notera que la première partie du dispositif suivant l'invention, c'est-à-dire le comparateur 1 et ses connexions est semblable au dispositif DAC de la figure 2. On y trouve en effet la ligne à retard 3 donnant un retard td à l'impulsion qui lui est appliquée et l'ensemble R1 R2 des résistances 5 et 6 qui donne une atténuation

$$k=\frac{R2}{R1+R2}<1$$

à l'impulsion qui lui est appliquée.

Le dispositif suivant l'invention, tel que présenté figure 6 doit fonctionner de façon correcté, quel que soit le type d'impulsion qui est appliquée à sont entrée E, c'est-à-dire que cette impulsion soit rapide ou quelle soit lente. Il faut donc envisager au moins deux modes de fonctionnement pour ce dispositif, suivant que l'impulsion reçue présente par exemple un temps de montée rapide inférieur à 1μs par exemple ou un temps de montée lent compris entre 1 et 3 μs.

Lorsqu'il n'y a pas de signal vidéo issu du circuit détecteur 15, c'est-à-dire que le circuit ne reçoit aucune impulsion, il n'existe à l'entrée du dispositif que le bruit, en l'occurrence du récepteur, transmis par le détecteur 15. Ce bruit est appliqué aux entrées positives des comparateurs 1 et 9 et se trouve atténué dans le rapport k sur l'entrée négative du comparateur 1. Ce comparateur est de la sorte très souvent déclenché par le bruit et son niveau oscille continuellement entre 1 et 0 logique.

La valeur de la tension de polarisation Vp de la source connectée par 13 à l'entrée négative du comparateur 9 est réglée au dessus de la valeur du bruit, atténué toutefois par le filtre RC 10 et de ce fait le niveau de sortie du comparateur 9 est bas, soit 0 logique.

La porte ET 14 lorsqu'elle reçoit sur ses entrées 16, 17 un signal 1 et un signal 0 a sa sortie au niveau 0, et le dispositif suivant l'invention ne délivre aucune information. Dans l'utilisation préférentielle envisagée, cette sortie est connectée à un décodeur du DME, qui dans ce cas ne reçoit pas d'information.

Dans ce qui soit, on va décrire le fonctionnement du dispositif, lorsqu'il reçoit une impulsion vidéo dont le temps de montée est rapide, c'est-à-dire que tr est inférieur à 1µs selon les hypothèses faites.

Cette impulsion vidéo est retardée d'une part d'une temps td dans la ligne à retard, puis appliquée sur l'entrée non inverseur c'est-à-dire positive du comparateur 1. Cette impulsion non retardée mais atténuée d'un coefficient k<1 est appliquée à l'entrée inverseur c'est-à-dire négative du comparateur l'également.

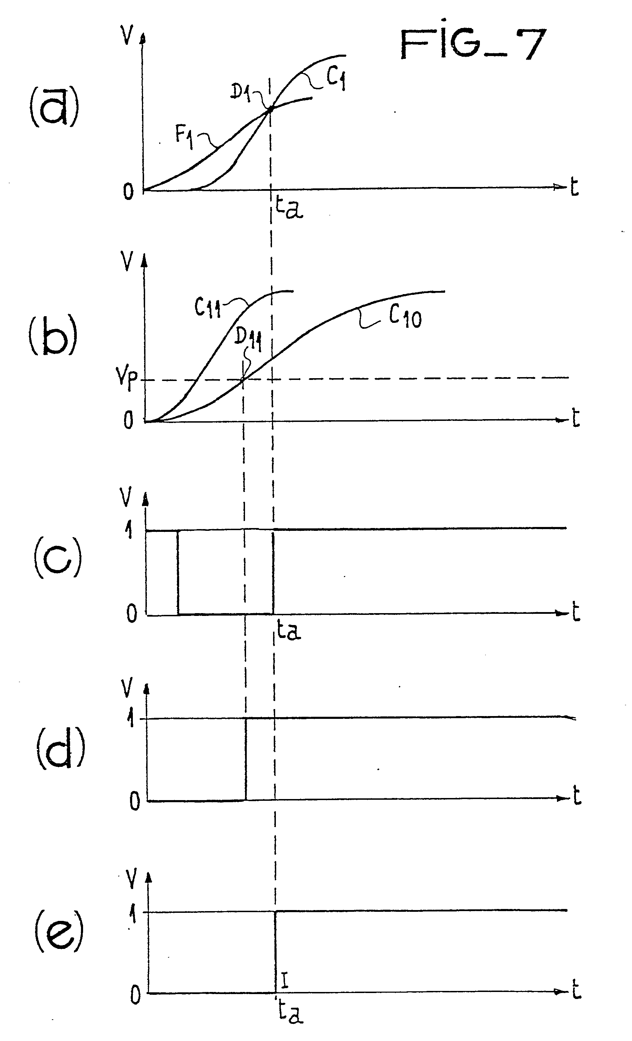

La figure 7a montre en fonction du temps, l'allure des signaux appliqués au comparateur 1 du dispositif selon l'invention; la courbe C1 représente l'impulsion rapide retardée et la courbe F1 cette impulsion atténuée mais non retardée.

En l'absence d'impulsion vidéo, on a vu que la sortie du comparateur 1 est à son niveau haut en général, c'est-à-dire 1 logique. Après réception de l'impulsion vidéo, lorsque l'impulsion atténuée F1 mais non retardée présente une amplitude supérieure à l'impulsion retardée C1 (figure 7a), la sortie du comparateur 1 change d'état et passe au niveau bas soit 0 logique. Cet état se maintient jusqu'à l'instant où l'impulsion retardée C1 devient égale en amplitude, point D1, àt l'impulsion non retardée F1 mais atténuée. A cet instant, le comparateur 1 change d'état et sa sortie passe à nouveau à son niveau haut. Cet instant, abscisse du point D1 sur l'axe des temps t, soit ta, caractérisé l'instant d'arrivée de l'impulsion rapide appliquée au dispositif. Cet instant d'arrivée sera délivré par le dispositif suivant l'invention et donc reçu par le décodeur connecté en sortie du circuit ET 14 comme définissant le passage du niveau 0 au niveau 1 de la sortie S, si la porte ET 14 laisse passer cette impulsion; pour ce fair il est nécessaire que son entrée 17 soit également au niveau haut, et donc, la sortie du comparateur 9 doit être également au niveau haut à cet instant. Cet état est obtenu lorsque le signal vidéo, courbe C11 de la figure 7b qui passe à travers la cellule RC 10 dépasse en niveau la tension seuil Vp (point D11). Ce circuit RC formant un intégrateur, réduit le temps de montée de l'impulsion rapide C11 qui est appliquée au comparateur 9 et filtre également le bruit sur cette voie. La constante de temps RC est calculée de sorte que l'impulsion C10 dont le front de montée est ainsi allongé par la cellule RC 10, croise le seuil Vp, au point D11 avant que la sortie 16 du comparateur 1 passe à l'état 1. Dans ces conditions lorsque les sorties 16 (courbe de la figure 7c) et 17 (courbe de la figure 7d) du circuit ET 14 sont au niveau 1, la sortie S délivre une impulsion indiquant l'instant d'arrivée ta de l'impulsion rapide (figure 7e), au point I.

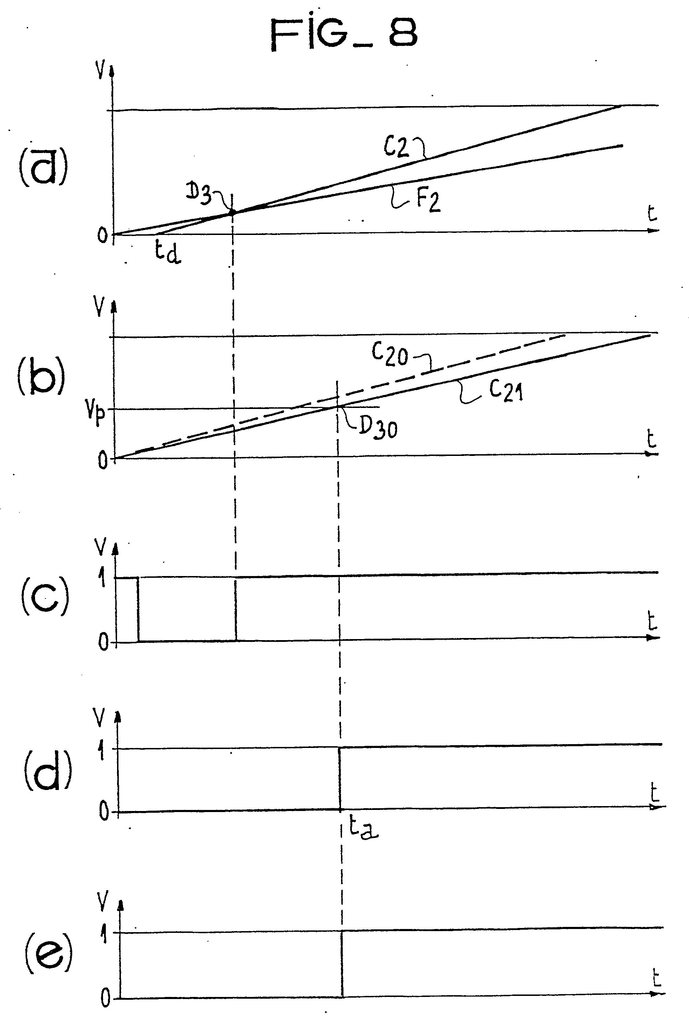

Dans ce qui suit, on va décrire le fonctionnement du dispositif selon l'invention lorsque l'impulsion appliquée présente un temps de montée lent, c'est-à-dire suivant les hypothèses faites, que le temps de montée tr est compris entre 1 et 3 µs. Généralement il est égal à 2,5 µs. Les courbes de la figure 8a à 8e aideront à mieux comprendre ce fonctionnement.

Avant l'arrivée de l'impulsion lente appliquée à l'entrée E du dispositif, la sortie 16 du comparateur 1 est au niveau 1. Après l'arrivée de l'impulsion, l'entrée négative du comparateur reçoit l'impulsion vidéo F2 atténuée, non retardée dont l'amplitude dépasse celle de l'impulsion retardée C2 appliquée à l'entrée non-inverseur c'est-à-dire positive (figure 8a). La sortie 16 du comparateur 1 est alors au niveau 0. Cependant l'impulsion retardée C2 dépasse rapidement en amplitude l'impulsion atténuée F2 et dans ces conditions la sortie 16 passe à nouveau au niveau 1 (courbe 8c). Toutefois l'information disponible à la sortie du comparateur 1 ne peut passer à travers la porte ET 14, dont la seconde entrée 17 se trouve au niveau 0. Comme le seuil Vp (figure 8b) sur l'entrée inverseur c'est-à-dire négative du comparateur 9 est réglé plus haut que le niveau du point de croisement D3 des signaux lents C2 et F2 sur l'entrée du comparateur 1, la sortie du comparateur 9 reste au niveau bas jusqu'à l'instant où l'impulsion vidéo C21 passée à travers le filtre RC 10 dépasse le seuil Vp (courbe 8b), point D30.

A cet instant, la sortie 17 du comparateur 9 passe au niveau 1 (courbe 8d), et la sortie S de la porte ET 14 et donc du dispositif délivre une impulsion (courbe 8e) qui est transmise au décodeur de l'équipement DME dans le cas où le dispositif est intégré à cet équipement, cette impulsion déterminant le temps d'arrivée de l'impulsion lente considérée.

Ainsi la détermination de l'instant d'arrivée de l'impulsion lente s'effectue non par le comparateur 1, mais par le comparateur 9 dont l'entrée non-inverseur, positive reçoit le signal vidéo à travers un filtre RC 10 dont la bande passante à-3 dB sera adaptée à la valeur minimum et maximum des impulsions à recevoir dans le cas de l'utilisation dans un DME.

Par rapport à la bande passante à fréquence intermédiaire de 2 à 4 MHz du récepteur d'un DME, ce circuit de filtrate RC assure une réduction de plusieurs dB du bruit sur cette voie. Donc la détection de l'impulsion lente est réalisée dans des conditions favorables à ce type d'impulsion (bande passante vidéo étroite).

Si l'on compare les résultats obtenus avec le dispositif suivant l'invention avec ceux du circuit DAC de la figure 3, on constate que pour ce dernier pour un exemple pris avec les paramètres td=0,3 µs, k=0,5, tr=0,6 µs (T=0,8 µs pour une montée linéaire 0 à 1) la détermination de l'instant d'arrivée d'une impulsion rapide est obtenue à un niveau de l'ordre de 0,38 de l'amplitude maximale de l'impulsion rapide retardée non atténuée tandis que la détermination de l'instant d'arrivée d'une impulsion lente de temps de montée de l'ordre de 2,5 µs est obtenue à un niveau de 0,13 de l'amplitude maximale sur l'impulsion retardée et non atténuée, le seuil de protection Vp étant choisi légèrement au-dessus de cette valeur, soit à 0,15 de l'amplitude maximale.

Dans ces conditions, pour assurer une protection contre les pointes de bruit à 2σ la valeur 1σ du bruit ne doit pas dépasser 0,075 A max, σ représentant la valeur efficace du bruit.

Le circuit DAC de l'art antérieur nécessite pour un fonctionnement correct un rapport signal/bruit de:

$$\frac{A \max}{0,075A \max} = 13,33 \text{ soit de } 22,5 \text{ dB.}$$

Avec le dispositif suivant l'invention, la détermination de l'instant d'arrivée de l'impulsion rapide s'effectue dans les mêmes conditions qu'avec le dispositif DAC, soit à 0,38 de l'amplitude maximale et la détermination de l'instant d'arrivée de l'impulsion lente sera obtenue sur le niveau de seuil réglé à 0,15 de l'amplitude maximale. Le filtre RC dont la bande passante est de l'ordre de 320 kHz réduit la puissance du bruit par rapport au bruit dans une bande passante de 4 MHz nécessaire pour la transmission du signal rapide, dans un rapport de 4, soit un rapport de 2 en amplitude (6dB).

Le rapport signal sur bruit pris par rapport au seuil de comparaison 0,15 A avant le filtre RC peut être pris égal à 1 pour assurer une protection de niveau de 2σ à l'entrée du comparateur 9. Dans ce cas, le rapport signal sur bruit minimum avec lequel le dispositif est capable de fonctionner est de:

$$\frac{S}{N} = \frac{A \max}{0.15A \max} = 6,67 \qquad \text{soit: } 16,5 \text{ dB}$$

La comparaison des deux rapports S/N à la sortie du détecteur 15 (figure 6) fait apparaître un gain de (22,5—16,5)=6 dB en faveur du dispositif object de l'invention.

Ces 6 dß permettent ou une réduction équivalente de l'ordre de 4 fois en puissance de l'émetteur pour une portée déterminée, ou l'augmentation de la portée de l'ordre de 2 fois, de l'émetteur pour une puissance donnée, par rapport à un circuit DAC figure 3. Mais le plus souvent le gain obtenu sur le bruit sera utilisé pour une meilleure protection contre les faux déclenchements sur le bruit.

On a vu dans le disposit suivant l'invention, décrit à l'aide de la figure 6 que, le comparateur 9, associé au comparateur 1 pour permettre le traitement dans un même dispositif d'impulsions à front de montée court et d'impulsions à front de montée plus long, était alimenté à travers un circuit agissant de façon générale sur le bruit, pour principalement dans le cas de la détermination de l'instant d'arrivée d'une impulsion lente améliorer le rapport signal sur bruit et adapter la bande passante du dispositif à celle plus petite nécessaire à la transmission de l'impulsion lente.

Ce circuit d'action sur le rapport signal sur bruit est dans le dispositif de la figure 6, un circuit RC, composé de la résistance 11 et du condensateur 12.

Il est des cas où on ne souhaite pas réduire la bande passante du comparateur 9, mais on veut néanmoins obtenir une meilleure protection contre le bruit, dans le but d'éviter de faux déclenchements du comparateur 9 sur des pointes de bruit dépassant le seuil établi par la tension de polarisation Vp et où généralement on veut choisir un point de décision plus haut sur l'impulsion lente. Dans ce cas une version modifiée de la figure 6 sera utilisée.

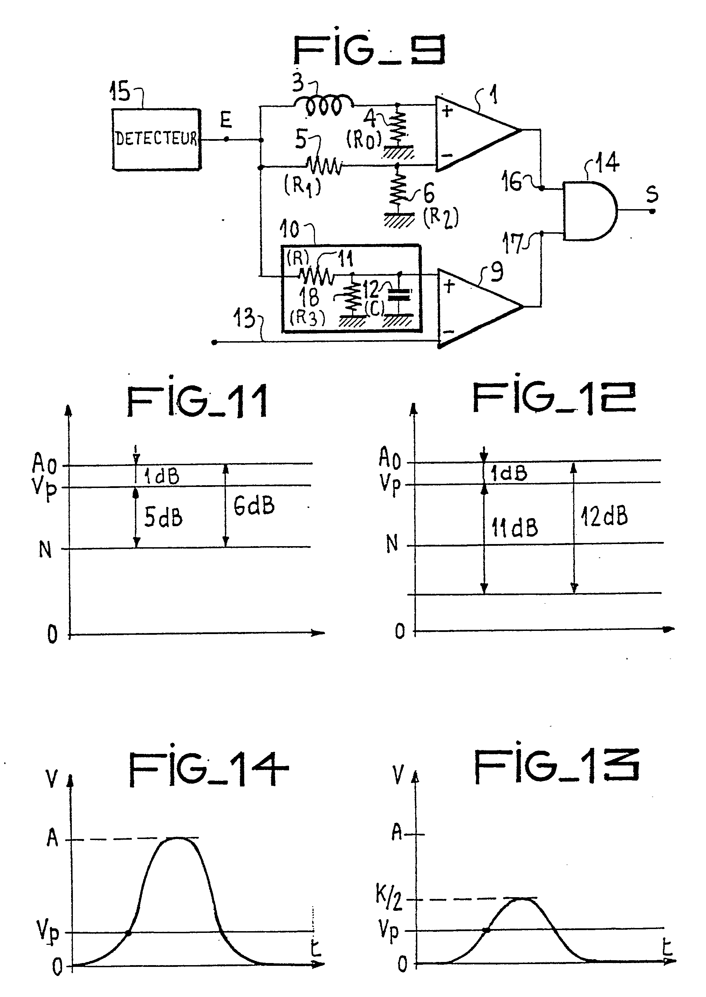

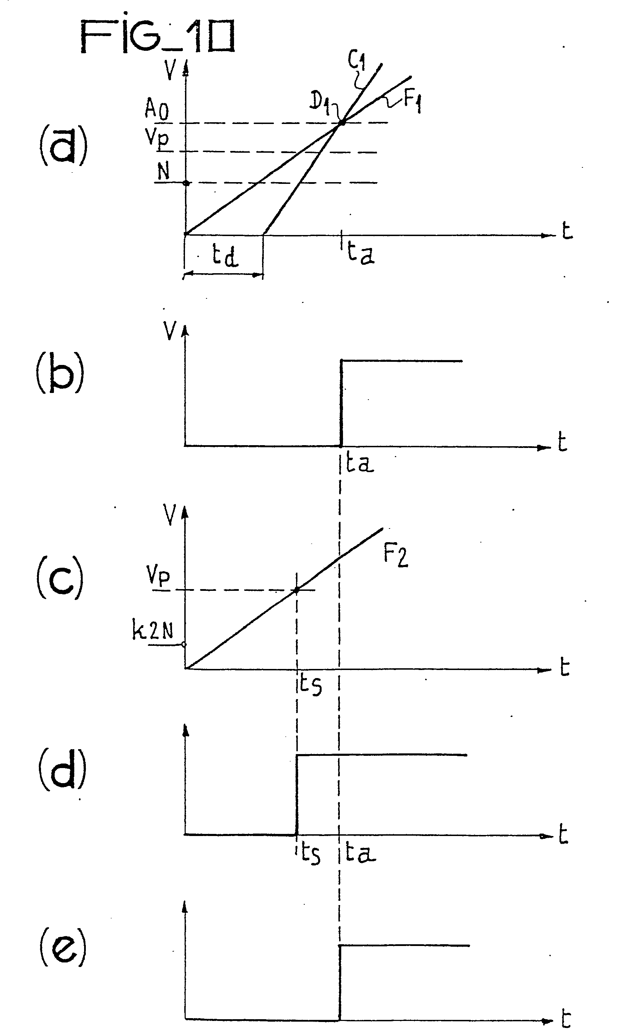

La figure 9 reprend la figure 6 dans laquelle l'ensemble RC 10 est remplacé par un diviseur de tension constitué par la résistance 11 de valeur R et une résistance 18 de valeur R3, mise en parallèle sur le condensateur C. Il faut noter que celui-ci alors, jouant un rôle moins important, peut être à limite supprimé.

Dans ces conditions, admettant que le condensateur C est supprimé, le comparateur 9 est connecté à un diviseur de tension présentant un coefficient d'atténuation

$$k2 = \frac{R3}{R+R3} < 1$$

Cet atténuateur n'agit pas sur la bande passante vidéo du dispositif, mais le signal vidéo, en l'occurrence l'impulsion appliquée à l'entrée E du dispositif qui est appliquée également au comparateur 9, subit une atténuation dans le rapport k2. Cette atténuation affaiblit également l'amplitude du bruit sur l'entrée positive du comparateur 9. Comme la tension de seuil Vp n'est pas modifiée on peut noter que la protection contre les déclenchements intempestifs du comparateur 9 sur des pointes de bruit dont l'amplitude dépasse celle du seuil est accrue et ce dans le rapport 1/k2.

Cette disposition avantageuse ne nuit pas à la détermination de l'instant d'arrivée d'une impulsion à front de montée rapide qui est, comme on l'a vu précédemment, exécutée par le comparateur 1 sous le contrôle du comparateur 9. En fait l'introduction de la résistance R3 en parallèle sur le condensateur C, et également si le condensateur est supprimé, n'a pas d'action sur le niveau du seuil Vp qui reste choisi suivant l'invention, à un niveau inférieur à celui du point de croisement D1 de l'impulsion retardée et de l'impulsion atténuée mais non retardée, appliquées aux entrées du comparateur 1. En effet, dans ces conditions le comparateur 9 sera toujours au niveau logique 1 avant que le comparateur 1 passe au niveau 1. La porte ET 14 dans ces conditions délivrera une impulsion marquant l'instant d'arrivée de l'impulsion appliquée à l'entrée E du dispositif.

Les figures 10a à e aident à mieux comprendre le fonctionnement du dispositif de la figure 9.

Sur la figure 10a, relative au comparateur 1, on a indiqué l'impulsion à front de montée rapide C1 retardée du temps td et cette impulsion non retardée mais atténuée F1 par le circuit diviseur R1, R2, qui coupe la précédente au point D1 marquant l'instant d'arrivée de l'impulsion. Par N on désigne l'amplitude du bruit, correspondant à ce que l'on appelle le niveau efficace du bruit 1σ; par Vp on désigne la tension de seuil et par Ao la tension au point de croisement que l'on peut appeler également amplitude de décision.

La figure 10b donne l'impulsion sortant du comparateur 1.

Sur la figure 10c, relative au comparateur 9, on a figuré l'impulsion F2 qui est celle d'entrée, mais atténuée dans le rapport k2 par le circuit diviseur RR3. On a figuré également le seuil Vp et le niveau k2N, amplitude atténuée du bruit. La figure 10d représente l'impulsion de sortie du comparateur 9 au temps ts et la figure 10e l'impulsion de sortie du dispositif suivant l'invention.

Le rapport entre l'amplitude de la tension de seuil de protection Vp qui est donc le seuil de protection et l'amplitude de bruit N à 1σ, unité de niveau efficace de bruit, détermine le taux de protection contre les déclenchements sur le bruit. Pour le comparateur 1 considéré seul, ce rapport sera:

$$m1 = \frac{Vp}{N}$$

Pour le comparateur 9 le rapport est:

$$m2 = \frac{Vp}{k2N}$$

k2 étant le coefficient d'atténuation donné par le circuit RR3 (11—18). On peut en déduire le gain obtenu par l'utilisation du comparateur 9 qui est:

$$G = \frac{m1}{m2} = \frac{1}{k2}$$

comme k2<1, G>1, donc l'introduction de la résistance R2 produit une amélioration importante de la protection contre les faux déclenchements sur le bruit.

A titre d'exemple, avec les valeurs habituelles de l'atténuation k et du retard td pour le comparateur 1, l'atténuation k2 peut être de l'ordre de 0,5 donc 1/k2=2 soit 6 dB pour le gain sur la protection contre les faux déclenchements sur le bruit.

Cette amélioration permet soit de fonctionner avec un rapport signal sur bruit plus faible pour la détermination du temps d'arrivée des impulsions, tout en ayant une très bonne protection contre les déclenchements parasites sur le bruit, soit d'avoir une plus grande probabilité de détection sans fausse alarme pour un rapport signal bruit donné au détecteur vidéo 15.

Si on considère un circuit DAC de l'art antérieur pour lequel le niveau du bruit (1σ) est à 6 dB au-dessous du niveau de décision Ao, plaçant le seuil Vp de protection à 1 dB au-dessous du niveau Ao de décision, on obtient une protection contre le bruit de l'ordre de 5 dB (Vp=1,78σ).

Avec le dispositif selon l'invention (figure 9) le coefficient d'atténuation est de l'ordre de k2=0,5 et en gardant le seuil Vp sur le comparateur 9 à 1 dB au-dessous du niveau de croisement Ao (figure 10a), le niveau de protection sur le bruit est de 11 dB (soit 3,55σ). Le gain correspondant est de 1/k2=2 soit 6 dB.

Il en résulte que si on se contente d'une protection de 2 donnant 95% de probabilité de non déclenchement, il est possible de travailler avec un rapport signal sur bruit plus faible.

Les figures 11 et 12 relatives respectivement au dispositif de l'art antérieur et au dispositif suivant l'invention, variante de la figure 9 illustrent les considérations précédentes.

Dans ce qui précède on a considéré le cas où l'impulsion appliquée au dispositif était à front de montée rapide. Dans ce qui suit on envisage l'application d'une impulsion à front de montée lent.

Dans ce cas, comme pour le dispositif de la figure 6, la décision sera obtenue par le comparateur 9, qui alors réduit l'amplitude du signal vidéo qui lui est appliqué dans le rapport k2 inférieur à 1, pour une valeur de la tension de seuil Vp qui reste inchangée. On obtient de la sorte la détermination de l'instant d'arrivée de l'impulsion à front de montée lent à un niveau plus haut sur le front de montée de l'impulsion, comme le montre la figure 13 où par le jeu de l'atténuation apportée par le circuit R3R, l'amplitude maximale atteinte par l'impulsion est de l'ordre de A/2 alors qu'elle est A dans le cas de la figure 14 où le circuit agissant sur le bruit est un circuit RC (figure 6).

Ainsi, lorsque le comparateur 9 est alimenté à travers un circuit RC, on peut adapter la bande passante vidéo au front de montée lent de l'impulsion.

Lorsque le comparateur 9 est alimenté à travers un circuit atténuateur (k2<1) on peut effectuer la détermination de l'instant d'arrivée d'une impulsion lente à un niveau plus haut sur l'impulsion, par exemple à "mi-hauteur" (figure 13) qui est souvent pris comme niveau de référence dans beaucoup de systèmes. Toutefois, dans ce cas la bande passante vidéo reste large c'est-à-dire non adaptée à la bande de l'impulsion lente.

Cependant, il est possible de ne pas supprimer le condensateur qui se trouvant en parallèle sur la résistance R3 permet, comme pour le cas précédent de réduire la bande passante vidéo pour cette impulsion à front de montée lent.

On a ainsi décrit un dispositif de détermination précisé de l'instant d'arrivée d'une impulsion àt front de montée rapide et d'une impulsion à front de montée lente. Cette détermination précise est particulièrement intéressante, comme cela a été déjà dit, dans des équipements de mesure de la distance où cette mesure est réalisée, a partir de la connaissance du temps de parcours d'une impulsion entre deux points.

Cette application particulièrement intéressante est un équipement de mesure de distances, plus connu sous le sigle DME-atterrissage (distance measuring equipment) qui a été défini quand la connaissance précise de la distance d'un aéronef à un aéroport, ou plus précisément de la distance à laquelle se trouve un aéronef en approche de son point d'atterrissage s'est révélée de plus en plus pressant étant donné d'une part la vitesse accrue des aéronefs et d'autre part, l'accroissement de la densité des aéronefs sur les lignes aériennes et aux approches des aéroports.

Les équipements DME en route sont connus qui peuvent se contenter d'une précision un peu moindre, et qui utilisent des dispositifs de détermination d'instants d'arrivée d'impulsions de l'art antérieur. Pour répondre aux besoins actuels de précision on incorpore des dispositifs de détermination d'instants d'arrivée d'impulsion, suivant l'invention, dans des équipements de mesure de distances.

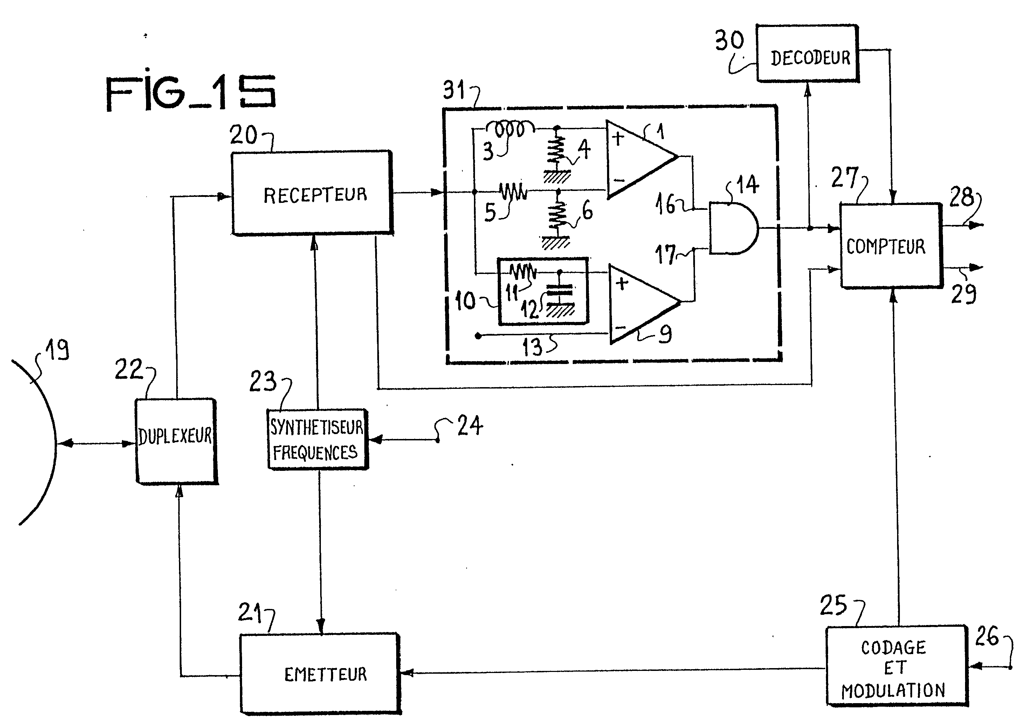

La figure 15 décrit de façon simplifiée un équipement DME dit interrogateur placé à bord d'un aéronef.

. Il comprend une antenne 19 connectée à un récepteur 20 et à un émetteur 21 à travers un duplexeur 22 on commutateur T/R. Un synthétiseur de fréquence 23 avec une commande de sélection de canal 24 est connecté au récepteur 20 et à l'émetteur 21. Cet émetteur est commandé par un circuit de codage et modulation 25 pour lequel on peut choisir le mode d'interrogation 26. Le récepteur 20 qui n'est pas détaillé et comprend l'étage détecteur vidéo est connecté au circuit 31 qui est le dispositif de détermination des instants des impulsions, suivant l'invention. Ce circuit 31 est connecté à un circuit décodeur 30 qui alimente un compteur distance et un processeur 27 délivrant en 28 la distance et en 29 la vitesse de déplacement. De plus le codeur 25 est connecté au compteur 27.

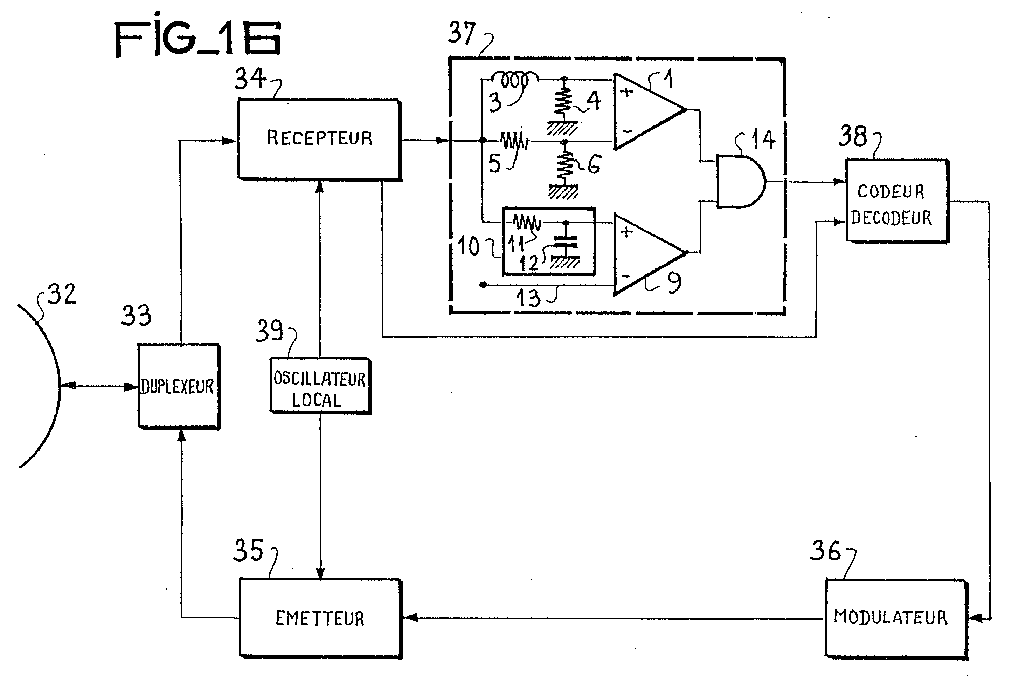

La figure 16 représent également sous la forme d'un schéma simplifié une station DME au sol, un transpondeur.

Il comprend principalement une antenne 32 connectée à travers un duplexeur 33 à un récepteur 34 et à un émetteur 35 alimenté par un modulateur 36. Le récepteur 34 est connecté à un circuit 37 qui est le dispositif de détermination des instants d'arrivée d'impulsions suivant "invention, circuit 37 qui alimente un circuit 38 décodeur et codeur connecté à un modulateur 36; un oscillateur local 39 est prévu alimentant le récepteur 34 et l'ensemble 35.

Du point de vue du fonctionnement, l'aéronef par son interrogateur interroge la station au sol qui répond et l'interrogateur mesure le temps qui s'écoule entre l'instant d'interrogation et l'instant où il reçoit la réponse, et convertit ce temps en distance.

L'interrogateur à bord, par son émetteur 20 et l'antenne 19 transmet des impulsions d'interrogation qui sont reçues par le récepteur 34 connecté à l'antenne 32. L'instant d'arrivée des impulsions d'interrogation est déterminé par le circuit 37 qui est connecté au décodeur 38. Celui-ci connecté au modulateur 36, déclenche l'émetteur 35 qui renvoie à l'interrogateur des impulsions de réponse.

Ces impulsions sont captees par l'antenne 19 de l'interrogateur, traitées dans le récepteur 20 et leur instant précis d'arrivée détecté dans le circuit 31, connecté au décodeur 30 et au compteur 27. Ce compteur ayant été mis en marche lors de l'émission des impulsions d'interrogation est arrêté lors de l'arrivée des impulsions de réponse de la station au sol, arrivée déterminée avec précision par le circuit 31 dont le fonctionnement a été décrit précédemment et qui ne sera pas donc repris.

Le nombre d'impulsions d'horloge comptées par le compteur 27 donne le temps mis par ces impulsions d'interrogation pour faire l'aller retour avec la station, et l'on en débuit la distance qui sépare l'aéronef de la station au sol.

Il ne paraît pas nécessaire de détailler plus avant le fonctionnement d'un DME équipé du dispositif de détermination des instants d'arrivée d'impulsions suivant l'invention.

A titre de produit nouveau, la présente demande couvre également les équipements DME dans lesquels sont incorporés les dispositifs suivant l'invention.

**Revendications**

1. Dispositif de détermination de l'instant d'arrivée d'impulsions comprenant des premiers moyens (1) de comparaison recevant sur une entrée l'impulsion vidéo ($C_1$) dont on veut déterminer l'instant d'arrivée et qui est retardée d'un temps défini et sur une autre entrée cette impulsion non retardée mais atténuée ($F_1$), ces moyens délivrant une information temporelle correspondant au point de croisement des deux impulsions ($D_1$), situé à un niveau supérieur à une tension de seuil définissant le niveau du bruit maximum du dispositif, caractérisé par le fait qu'il comporte en outre des seconds moyens de comparaison (9) connectés en parallèle sur les premiers (1) à un circuit logique ET (14) et des moyens d'action (10) par filtrage du bruit et/ou du signal qu'il reçoit, recevant les impulsions appliquées à l'entrée (E) du dispositif et ayant leur sortie connectée à une entrée des seconds moyens de comparaison (9), dont l'autre entrée est connectée à une source de tension de polarisation (Vp) d'un niveau juste supérieur au niveau du bruit, le circuit logique ET (14) délivrant une impulsion marquant l'instant d'arrivée suivant le cas d'une impulsions à front de montée rapide ou d'une impulsion à front de montée lent.

2. Dispositif de détermination suivant la revendication 1, caractérisé par le fait que les moyens de comparaison (9) et (1) sont des amplificateurs différentiels dont les entrées sont connectés à l'entrée (E) du dispositif et dont les sorties sont respectivement connectées aux deux entrées (16—17) du circuit logique ET (14) dont la sortie (S) constitue la sortie du dispositif.

3. Dispositif de détermination suivant la revendication 1, caractérisé par le fait que 'e circuit d'action (10) consiste en un circuit RC (11—12) jouant le rôle d'un filtre passe-bas.

4. Dispositif de détermination suivant l'une des revendications 1, 2 ou 3, caractérisé par le fait que recevant une impulsion à front de montée rapide, l'instant d'arrivée de ladite impulsion est déterminée par le premier comparateur (1).

5. Dispositif de détermination suivant l'une des revendications 1, 2 ou 3, caractérisé par le fait que recevant une impulsion à front de montée lent, l'instant d'arrivée de ladite impulsion est déterminé par le second comparateur (9).

6. Dispositif de détermination suivant la revendication 3, caractérisé par le fait que la bande passante du circuit d'action, résistance (11) capacité (12), est adaptée à celle des impulsions du signal vidéo.

7. Dispositif de détermination suivant la revendication 1, caractérisé par le fait que le circuit d'action (10) est constitué par un point diviseur (11—18) atténuant dans un rapport donné toute impulsion qui lui est appliquée.

8. Dispositif de détermination suivant la revendication 7, caractérisé par le fait qu'une capacité (12) est montée en parallèle sur la résistance (18).

9. Dispositif de détermination suivant la revendication 7, caractérisé par le fait que l'atténuation produite par le circuit diviseur (11—18) atténue dans un rapport donné le bruit appliqué au second comparateur, évitant le basculement dudit comparateur sur des pointes de bruit dépassant le niveau de la tension de seuil (Vp).

10. Utilisation d'un dispositif de détermination de l'instant d'arrivée d'impulsions, selon les revendications 1 à 9 dans un équipement de mesure de distance (DME), caractérisé par le fait qu'un tel dispositif (31—37) est intercalé dans un interrogateur DME ainsi que dans un transpondeur au sol, entre le récepteur (20—34) et un circuit de décodage (30—38).

11. Utilisation d'un dispositif de détermination suivant la revendication 10, caractérisé par le fait que l'impulsion délivrée par le dispositif (31) dans un interrogateur, marquant l'instant d'arrivée d'une impulsion à front de montée rapide ou lent, en provenance d'un transpondeur au sol arrête un compteur (27) mis en marche lors de l'émission d'une impulsion d'interrogation, axu fins de détermination de la distance (28) séparant un aéronef porteur d'un interrogateur d'une station au sol ou de détermination de la vitesse d'évolution de ladite distance (29).

12. Utilisation d'un dispositif de détermination suivant la revendication 10, caractérisée par le fait que l'impulsion délivrée par le dispositif (37) dans un transpondeur au sol, marquant l'instant d'arrivée d'une impulsion à front de montée rapide ou lent, en provenance de l'interrogateur, est appliquée à un codeur décodeur (38) déclenchant un émetteur (35) envoyant une impulsion de réponse de même type à l'interrogateur.

13. Equipement de mesure de distance DME interrogateur, ou transpondeur, caractérisé par le fait qu'il comprend en sortie du récepteur (34, 20) un dispositif de détermination de l'instant d'arrivée d'impulsions à front de montée rapide ou lent suivant l'une quelconque des revendications 1 à 9.

## Patentansprüche

1. Vorrichtung zur Bestimmung des Ankunftszeitpunktes von Impulsen, mit ersten Vergleichermitteln (1), welche an einem Eingang den Videoimpuls ($C_1$) empfangen, dessen Ankunftszeitpunkt bestimmt werden soll und der um eine definierte Zeit verzögert ist, sowie an einem anderen Eingang diesen unverzögerten, jedoch gedämpften Impuls ($F_1$) empfangen, wobei diese Mittel eine Zeitinformation ausgeben, welche dem Kreuzungspunkt der zwei Impulse ($D_1$) entspricht, der auf einem höheren Niveau als eine Schwellwertspannung liegt, welche den maximalen Rauschpegel der Vorrichtung definiert, dadurch gekennzeichnet, daß sie ferner zweite Vergleichermittel (9) enthält, die parallel mit den ersteren (1) an eine AND-Logikschaltung (14) angeschlossen sind, und Wirkungsmittel (10) enthält, welche mit Filterung des Rauschens und/oder des empfangenen Signals arbeiten sowie die an den Eingang (E) der Vorrichtung angelegten Impulse empfangen und ausgangsseitig mit einem zweiten Eingang der zweiten Vergleichermittel (9) verbunden sind, deren anderer Eingang mit einer Polarisationsspannungsquelle (Vp) verbunden ist, deren Pegel etwas oberhalb des Rauschpegels liegt, wobei die AND-Logikschaltung (14) einen Impuls abgibt, welcher den Ankunftszeitpunkt markiert, und zwar je nach Fall eines Impulses mit schneller Anstiegsflanke oder eines Impulses mit langsamer Anstiegsflanke.

2. Bestimmungsvorrichtung nach Anspruch 1, dadurch gekennzeichnet, daß die Vergleichermittel (9) und (1) Differenzverstärker sind, deren Eingänge mit dem Eingang (E) der Vorrichtung verbunden sind und deren Ausgänge jeweils mit einem der zwei Eingänge (16, 17) der AND-Logikschaltung (14) verbunden sind, deren Ausgang (S) den Ausgang der Vorrichtung bildet.

3. Bestimmungsvorrichtung nach Anspruch 1, dadurch gekennzeichnet, daß die Wirkungsschaltung (10) aus einem RC-Glied (11, 12) besteht, welches die Funktion eines Tiefpaßfilters erfüllt.

4. Bestimmungsvorrichtung nach einem der Ansprüche 1, 2 und 3, dadurch gekennzeichnet, daß beim Empfang eines Impulses mit schneller Anstiegsflanke der Ankunftszeitpunkt dieses Impulses durch den ersten Vergleicher (1) bestimmt wird.

5. Bestimmungsvorrichtung nach einem der Ansprüche 1, 2 und 3, dadurch gekennzeichnet, daß beim Empfang eines Impulses mit langsamer Anstiegsflanke der Ankunftszeitpunkt dieses Impulses durch den zweiten Vergleicher (9) bestimmte wird.

6. Bestimmungsvorrichtung nach Anspruch 3, dadurch gekennzeichnet, daß das Durchlaßband der Wirkungsshaltung aus Widerstand (11) und Kapazität (12) an das der Impulse des Videosignals angepaßt ist.

7. Bestimmungsvorrichtung nach Anspruch 1, dadurch gekennzeichnet, daß die Wirkungsschaltung (10) durch eine Teilerbrücke (11—18) gebildet ist, welche jeden daran angelegten Impuls in einem gegebenen Verhältnis dämpft.

8. Bestimmungsvorrichtung nach Anspruch 7, dadurch gekennzeichnet, daß eine Kapazität (12) parallel zu dem Widerstand (18) geschaltet ist.

9. Bestimmungsvorrichtung nach Anspruch 7, dadurch gekennzeichnet, daß die durch die Teilerschaltung (11—18) erzeugte Dämpfung. das an den zweiten Vergleicher angelegte Rauschen in einem gegebenen Verhältnis dämpft, wodurch das Kippen dieses Vergleichers an Rauschpunkten vermieden wird, welche den Pegel der Schwellwertspannung (Vp) überschreiten.

10. Verwendung einer Vorrichtung zur Bestimmung des Ankunftszeitpunktes von Impulsen nach den Ansprüchen 1 bis 9 in einer Entfernungsmeßeinrichtung (DME), dadurch gekennzeichnet, daß eine solche Vorrichtung (31—37) in eine DME-Abfragegerät sowie in einen Boden-Antwortsender zwischen dem Empfänger (20—34) und einer Decodierschaltung (30—38) eingefügt ist.

11. Verwendung einer Bestimmungsvorrichtung nach Anspruch 10, dadurch gekennzeichnet, daß der von der Vorrichtung (31) in einem Abfragegerät abgegebene Impuls, welcher den Ankunftszeitpunkt eines Impulses mit schneller oder langsamer Anstiegsflanke aus einem Boden-Antwortsender markiert, einen Zähler (27) anhält, der in Betrieb gesetzt wird, wenn ein Abfrageimpuls ausgesendet wird, um die Entfernung (28) zwischen einem ein Abfragegerät tragenden Flugzeug und einer Bodenstation oder um die Evolutionsgeschwindigkeit dieser Entfernung (29) zu bestimmen.

12. Verwendung einer Bestimmungsvorrichtung nach Anspruch 10, dadurch gekennzeichnet, daß der von der Vorrichtung (37) in einem Boden-Antwortsender ausgegebene Impuls, welcher den Ankunftszeitpunkt eines Impulses mit schneller oder langsamer Anstiegsflanke aus dem Abfragegerät markiert, an einen Codierer-Decoder (38) angelegt wird, welcher einen Sender (35) auslöst, der einen Antwortimpuls gleicher Art zum Abfragegerät sendet.

13. DME-Entfernungsmeßgerät für Abfragegerät oder Antwortsender, dadurch gekennzeichnet, daß es am Ausgang des Empfängers (34, 20) eine Vorrichtung zur Bestimmung des Ankunftszeitpunktes von Impulsen mit schneller oder langsamer Anstiegsflanke nach einem der Ansprüche 1 bis 9 enthält.

Claims

1. Device for the determination of the moment of arrival of pulses, comprising first comparing means (1) receiving on an input the video pulse ($C_1$) the moment of arrival of which is to be determined and which is delayed by a defined time, and on another input the same, undelayed but attenuated pulse ($F_1$), these means supplying a time information corresponding to the crossing point of the two pulses ($D_1$) located at a level exceeding a threshold voltage defining the maximum noise level of the device, characterized by the fact that it further comprises second comparing means (9) connected in parallel with the first (1) to a logic AND circuit (14) and action means (10) operating by filtering the noise and/or the signal received thereby, receiving the pulses applied to the input (E) of the device and having their output connected to an input of the second comparing means (9) the other input of which is connected to a polarization voltage source (Vp) having a level just exceeding the noise level, the logic AND circuit (14) supplying a pulse marking the moment of arrival of pulses with rapid rising edge or a pulse with slow rising edge, as the case may be.

2. Determination device according to claim 1, characterized by the fact that the comparing means (9) and (1) are differential amplifiers the inputs of which are connected to the inputs (E) of the device and the outputs of which are respectively connected to two inputs (16—17) of the logic AND circuit (14) the output (S) of which forms the output of the device.

3. Determination device according to claim 1, characterized by the fact that the action circuit (10) consists in an RC circuit (11—12) forming a low-pass filter.

4. Determination device according to any of claims 1, 2 or 3, characterized by the fact that upon reception of a pulse with rapid rising edge the moment of arrival of said pulse is determined by the first comparator (1).

5. Determination device according to any of claims 1, 2 or 3, characterized by the fact that upon reception of a pulse with slow rising edge the moment of arrival of said pulse is determined by the second comparator (9).

6. Determination device according to claim 3, characterized by the fact that the pass band of the action circuit, resistor (11) and capacity (12), is adapted to that of the pulses of the video signal.

7. Determination device according to claim 1, characterized by the fact that the action circuit (10) is formed by a divider bridge (11—18) attenuating any pulse applied thereto with a given ratio.

8. Determination device according to claim 7, characterized by the fact that a capacity (12) is mounted in parallel to the resistor (18).

9. Determination device according to claim 7, characterized by the fact that the attenuation produced by the divider circuit (11—18) attenuates the noise applied to the second comparator in a given ratio whereby the toggling of said comparator is avoided at noise points exceeding the level of the threshold voltage (Vp).

10. Use of a device for the determination of the moment of arrival of pulses, according to claims 1 to 9 in a distance measuring equipment (DME), characterized by the fact that this device (31—37) is interposed in a DME interrogator as well as in a ground transponder between the receiver (20—34) and a decoding circuit (30—38).

11. Use of a determination device according to claim 10, characterized by the fact that the pulse applied by the device (31) in an interrogator marking the moment of arrival of a pulse with rapid or slow rising edge from a ground transponder stops a counter (27) which is enabled upon the transmission of an interrogation pulse, for the determination of the distance (28) between an aircraft carrying an interrogater and a ground station or for the determination of the evolution speed of said distance (29).

12. Use of a determination device according to claim 10, characterized by the fact that the pulse supplied by the device (37) in a ground transponder marking the moment of arrival of a pulse with rapid or slow rising edge from the interrogator is applied to a coder-decoder (38) enabling a transmitter (35) transmitting a response pulse of the same type to the interrogator.

13. DME distance measuring equipment of an interrogator or transponder, characterized by the fact that it comprises at the output of the receiver (34, 20) a device for the determination of the moment of arrival of pulses with rapid or slow rising edges according to any of claims 1 to 9.

11

# FIG_1

# FIG_2

# FIG_3

# FiG_4

# FiG_5

# FiG_6

FIG_7

(a)

(b)

(c)

(d)

(e)

# FIG_ 8

(a)

(b)

(c)

(d)

(e)

7

# FIG_9

# FIG_11

# FIG_12

# FIG_14

# FIG_13

FIG_10

FIG_15

FIG_16